# EUROPÄISCHE PATENTANMELDUNG

(11) **EP 1 770 766 A2**
(43) Veröffentlichungstag der Anmeldung: **04.04.2007**
(21) Anmeldenummer: 06019931.2
(22) Anmeldetag: 22.09.2006
(51) Int. Cl.: H01L 21/20

(54) **Epitaxiesubstrat, damit hergestelltes Bauelement sowie entsprechende Herstellverfahren**

(30) Priorität: 30.09.2005 DE 102005047149
(71) Anmelder: Osram Opto Semiconductors GmbH, 93049 Regensburg (DE)
(72) Erfinder: Plößl, Andreas, 93051 Regensburg (DE)
(74) Vertreter: Epping - Hermann - Fischer

(57) **Zusammenfassung**

Es wird ein III-V-Halbleiter aufweisendes Epitaxiesubstrat vorgeschlagen, das mindestens eine Schicht porösen III-V-Halbleitermaterials enthält, sowie ein entsprechendes Herstellverfahren. Ferner wird ein Bauelement, insbesondere eine LED, angegeben, das auf dem vorgeschlagenen Epitaxiesubstrat hergestellt ist, und ein entsprechendes Herstellverfahren.

## Beschreibung

Die Erfindung betrifft ein Epitaxiesubstrat, insbesondere zur Herstellung von Dünnschicht-Halbleiterchips auf der Basis von III-V-Halbleitern, sowie ein Verfahren zu dessen Herstellung. Weiter betrifft die Erfindung ein mit dem Epitaxiesubstrat hergestelltes Bauelement, insbesondere ein Strahlung emittierendes Bauelement und speziell eine LED ein Laser oder eine IR-Diode, und ein Verfahren zur Herstellung des Bauelements.

Die Verwendung von Dünnschicht-Halbleiterchips findet in den letzten Jahren, insbesondere bei der Herstellung von Strahlung emittierenden Bauelementen wie LEDs und Lasern eine immer größer werdende Bedeutung.

Ein derartiges Bauelement in Dünnschichttechnologie ist beispielsweise in der DE 100 59 532 beschrieben. Bei seiner Herstellung wird eine Leuchtdiodenstruktur auf einem Epitaxiesubstrat gewachsen, danach mit einem Ersatzsubstrat verbunden und in Anschluss die Leuchtdiodenstruktur von dem Epitaxiesubstrat getrennt. Die Abtrennung des Dünnschichtfilms geschieht dabei bisher meistens, indem nach der Verbindung des Dünnschichtfilms mit dem Ersatzsubstrat zunächst das Epitaxiesubstrat durch Schleifen gedünnt wird und danach in einem Ätzschritt die Reste des Epitaxiesubstrats entfernt werden. Das ursprüngliche Epitaxiesubstrat wird dabei vollständig zerstört. Es kann keine Wiederverwertung des Epitaxiesubstrats vorgenommen werden.

Eine Wiederverwertung von Epitaxiesubstraten ist insbesondere wünschenswert, da es sich dabei meistens um kostenaufwendige monokristalline Substrate handelt.

In dem Artikel A. Plößl et al.: "Silicon-on-Isolator: Materials Aspects and Applications", Solid-State Electronics 44 (2000) 775 - 782 ist ein weiteres Verfahren zur Herstellung von Dünnschicht-Halbleiterchips auf Siliziumbasis beschrieben, das das so genannte ELTRAN-Verfahren betrifft. Auf einem Siliziumepitaxiesubstrat mit einer porösen Schicht wird eine gewünschte Struktur gewachsen. Diese Struktur wird im Anschluss mit einem Ersatzsubstrat verbunden und das Wachstums-Epitaxiesubstrat mittels Durchtrennung der porösen Schicht von der gewachsenen Struktur und dem daran befestigten Ersatzsubstrat abgetrennt. Dieses Verfahren bietet den Vorteil, dass sich das monokristalline Siliziumepitaxiesubstrat nach Ablösung wieder verwenden lässt. Dieses Verfahren lässt sich, insbesondere wegen der dort vorhandenen unterschiedlichen Atomsorten, nicht auf III-V-Halbleitersysteme übertragen.

Ausgehend vom Stand der Technik liegt der Erfindung die Aufgabe zugrunde, eine Möglichkeit zur Substrattrennung bei einem anderen Materialsystem anzugeben.

Diese Aufgabe löst die Erfindung mit den Merkmalen der unabhängigen Patentansprüche.

Bevorzugte Ausführungsformen und Weiterbildungen der Erfindung sind Gegenstand der abhängigen Ansprüche.

Gemäß der Erfindung weist ein Epitaxiesubstrat, welches III-V-Halbleiter enthält, mindestens eine Schicht porösen III-V-Halbleitermaterials auf. Oberhalb der porösen Schicht können beliebige III-V-Halbleiterstrukturen gewachsen werden. Ein derartiges Substrat bildet den Vorteil, dass die darauf gewachsenen Strukturen zu einem späteren Zeitpunkt mittels Zerstörung der porösen Schicht oder mittels Durchtrennung der porösen Schicht von dem ursprünglichen Substratwafer gelöst werden können. Bei dem Epitaxiesubstratwafer kann der Waferanteil, welcher sich unterhalb der porösen Schicht befindet, zum Beispiel nach Anwendung einer Dünnschichttechnologie wieder verwendet werden.

Eine besonders bevorzugte Ausführungsform der Erfindung sieht vor, dass das Epitaxiesubstrat überwiegend III-V-Halbleitermaterialien aufweist. Durch Verwendung einer porösen Schicht bei Epitaxiesubstraten aus III-V-Halbleitermaterialien, insbesondere Galliumarsenidwafern, kann durch den Einsatz einer Schicht porösen III-V-Halbleitermaterials eine einfache Durchtrennung zwischen den gewachsenen Strukturen und dem Wafer erfolgen.

Eine vorteilhafte Ausführungsform der Erfindung entsteht, wenn die Porengröße der porösen Schicht in einem ersten Teilbereich größer als in einem zweiten Teilbereich ist. Bei der Herstellung eines erfindungsgemäßen Epitaxiesubstrats kann beispielsweise auf einem Galliumarsenidwafer durch elektrochemische Oxidation eine poröse Schicht erzeugt werden. Durch Steuerung der elektrochemischen Oxidation kann die Porengröße innerhalb der porösen Schicht variiert werden. Um die spätere Durchtrennung der porösen Schicht zu vereinfachen, sind bei erfindungsgemäßen Epitaxiesubstraten Trennschichten oder Trennschichtbereiche, die große Poren aufweisen, besonders bevorzugt.

Zur Erzeugung gewünschter Strukturen oberhalb der porösen Schicht muss die poröse Schicht wiederum gleichmäßig mit Halbleitermaterialien überwachsen werden. Dazu ist es vorteilhaft, wenn die poröse Schicht zumindest in einem Teilbereich eine geringe Porengröße aufweist. Das ist insbesondere vorteilhaft, wenn dieser zweite Teilbereich zwischen dem ersten Teilbereich mit großen Poren und der Wachstumsoberfläche des Epitaxiesubstrates liegt.

Eine weitere besonders bevorzugte Ausführungsform der Erfindung sieht vor, dass die kristallographische Fernordnung innerhalb der porösen Schicht beibehalten wird. Durch die Beibehaltung der kristallographischen Fernordnung kann auf einfache Art und Weise die poröse Schicht mit monokristallinen Lagen überwachsen werden, welche die gleiche kristallographische Ordnung aufweisen wie der unterhalb der porösen Schicht liegende Wafer. Dadurch können insbesondere Gitterfehler innerhalb der auf dem Epitaxiesubstrat zu wachsenden Strukturen minimiert oder sogar komplett verhindert werden.

Eine andere bevorzugte Ausführungsform der Erfindung sieht vor, dass die poröse Schicht durch einen III-V-Halbleiterkristall überwachsen ist. Die Oberfläche dieses III-V-Halbleiterkristalls ist insbesondere geeignet, um gewünschte Halbleiterstrukturen, beispielsweise LED-Strukturen, aufzuwachsen.

Eine besonders vorteilhafte Ausführungsform der Erfindung entsteht, wenn das Epitaxiesubstrat zusätzlich mindestens eine Ätzstoppschicht aufweist. Die mindestens eine Ätzstoppschicht liegt insbesondere in der Nähe der porösen Schicht. Soll zur Ablösung der auf dem Epitaxiesubstrat gewachsenen Strukturen mittels eines nasschemischen Ätzverfahrens die poröse Schicht zerstört werden, so können eine oder mehrere Ätzstoppschichten dazu benutzt werden, die die poröse Schicht umgebenden Schichten vor der Ätzlösung zu schützen.

Die Erfindung sieht weiterhin mit Vorteil vor, dass die Porengröße innerhalb der porösen Schicht mindestens einen Gradienten aufweist. Beispielsweise kann die Porengröße innerhalb der porösen Schicht derart variiert werden, dass sie von einem Zentrum beziehungsweise einer Mitte der Schicht zu den beiden Oberflächen der Schicht hin abnimmt. Dadurch entsteht in der Mitte der porösen Schicht ein Bereich, welcher besonders leicht durchtrennbar beziehungsweise zerstörbar ist. Weiters ermöglichen oder vereinfachen eine oder mehrere Übergangszonen zu den Oberflächen der porösen Schicht hin, in denen die Porengröße zunehmend abnimmt, ein gleichmäßiges Überwachsen der Schicht mit einem Halbleiterkristall, insbesondere einem monokristallinen Halbleiterkristall.

Eine weitere bevorzugte Ausführungsform der Erfindung entsteht, wenn auf der Oberfläche des Epitaxiesubstrats mindestens eine Leuchtdiodenstruktur angeordnet ist. Der Einsatz erfindungsgemäßer Epitaxiesubstrate bei der Herstellung von Leuchtdiodenchips ist besonders bevorzugt. Die Verwendung der Dünnschichttechnologie bei Leuchtdioden bietet insbesondere den Vorteil einer höheren Strahlungsausbeute, da sich erzeugtes Licht aus einem Dünnschichtfilm leichter auskoppeln lässt.

Eine weitere bevorzugte Ausführungsform der Erfindung weist auf der mindestens einen Leuchtdiodenstruktur mindestens eine Verbindungsschicht auf, die zur späteren Verbindung mit einem Ersatzsubstrat vorgesehen und geeignet ist. Ein derart vorbereitetes Epitaxiesubstrat kann sofort mit einem Ersatzsubstrat verbunden werden, beispielsweise durch Techniken wie Waferbonding, Kleben, Löten oder Tempern. Nach der festen Verbindung des Epitaxiesubstrats mit dem Ersatzsubstrat kann die poröse Schicht durchtrennt oder zerstört werden. Der dem ursprünglichen Epitaxiesubstrat zugrunde liegende Wafer kann entfernt und wieder verwendet werden.

Eine vorteilhafte Ausführungsform der Erfindung betrifft LED-Dünnfilmchips, die auf einem erfindungsgemäßen Epitaxiesubstrat gewachsen wurden. Derartige LED-Dünnfilmchips können auf kostengünstige Art und Weise hergestellt werden, da der monokristalline Wafer nach Durchtrennung beziehungsweise Zerstörung der porösen Schicht für weitere Epitaxieschritte wieder verwertet werden kann.

Die Erfindung betrifft auch ein Verfahren zur Herstellung erfindungsgemäßer Epitaxiesubstrate. Bevorzugt umfasst das Verfahren folgende Schritte: Bereitstellen eines III-V-Halbleiterwafers, insbesondere eines Galliumarsenidwafers, Herstellen einer porösen Schicht auf einer Oberfläche des Halbleiterwafers durch elektrochemische Oxidation und Überwachsen der Poren der porösen Schicht mit einem Halbleitermaterial, insbesondere einem III-V-Halbleitermaterial und speziell einem Galliumarsenidhalbleiter. Ein derartig hergestelltes Epitaxiesubstrat bildet die Grundlage für weitere epitaktische Schritte, mit deren Hilfe beliebige Halbleiterstrukturen und insbesondere III-V-Halbleiterstrukturen auf dem Epitaxiesubstrat oberhalb der porösen Schicht angeordnet oder erzeugt werden können.

Eine andere bevorzugte Ausführungsform des Verfahrens sieht vor, dass die Porenstruktur der porösen Schicht durch Steuerung der elektrochemischen Oxidation in einem ersten Teilbereich eine andere durchschnittliche Porengröße aufweist als in einem zweiten Teilbereich. Durch eine gezielte Steuerung der elektrochemischen Reaktion weist beispielsweise der erste Teilbereich der porösen Schicht, welcher weiter von der überwachsenen Halbleiterschicht entfernt liegt, eine größere Porengröße auf als ein zweiter Teilbereich, welcher näher an dieser Schicht liegt. Durch die Ausgestaltung verschiedener Teilbereiche mit verschiedenen Porengrößen wird erreicht, dass auf der zu überwachsenden Seite des Epitaxiesubstrates ein gleichmäßiger monokristalliner Halbleiterkristall mit nur wenigen Gitterstörungen entsteht.

Eine vorteilhafte Ausführungsform des Verfahrens entsteht, wenn nach dem Überwachsen der porösen Schicht auf der Oberfläche des überwachsenen Halbleiterkristalls mindestens eine LED-Struktur aufgewachsen wird.

Eine weitere bevorzugte Ausführungsform der Erfindung sieht vor, dass auf dem Epitaxiesubstrat oberhalb der weiteren Schichten eine Verbindungsschicht aufgebracht wird. Diese Verbindungsschicht ist insbesondere vorteilhaft, wenn sie dazu benutzt wird, das Epitaxiesubstrat mit einem Ersatzsubstrat zu verbinden.

Eine weitere bevorzugte Ausführungsform eines erfindungsgemäßen Verfahrens sieht vor, das Epitaxiesubstrat mittels eines Verbindungsschrittes mit einem Ersatzsubstrat zu verbinden. So kann der Transfer der erzeugten Dünnschichtstrukturen von dem Wachstumssubstrat zu dem Träger- oder Ersatzsubstrat erfolgen.

Eine besonders bevorzugte Ausführungsform eines Verfahrens zur Herstellung mindestens eines Dünnfilmhalbleiterchips sieht vor, auf einem Epitaxiesubstrat, das eine poröse, von einem Halbleiterkristall überwachsene Schicht enthält, LED-Strukturen aufzubringen. Danach wird dieses Epitaxiesubstrat mit den aufgebrachten LED-Strukturen mit einem Ersatzsubstrat verbunden, und mittels Durchtrennung der porösen Schicht werden die LED-Strukturen oberhalb der porösen Schicht von dem unterhalb der porösen Schicht liegenden Halbleiterkristall getrennt.

Vorteilhaft sieht das Verfahrens zur Herstellung eines oder mehrerer Dünnfilmhalbleiterchips vor, nach dem Abtrennen des Halbleitermaterials unterhalb der porösen Schicht die Leuchtdiodenstrukturen zu vereinzeln. Diese Vereinzelung kann durch Schleifen, Sägen, Schleifen, Brechen oder weitere Trennungstechniken erfolgen.

Die Erfindung wird nachfolgend anhand von Ausführungsbeispielen beschrieben, die in den Figuren der Zeichnungen dargestellt sind. Gleiche Elemente sind mit gleichen Bezugszeichen versehen. Es zeigen:
- Figur 1: eine schematische Querschnittsdarstellung eines erfindungsgemäßen Epitaxiesubstrats,
- Figur 2: eine weitere schematische Querschnittsdarstellung eines erfindungsgemäßen Epitaxiesubstrats,
- Figur 3: eine dritte schematische Querschnittsdarstellung eines erfindungsgemäßen Epitaxiesubstrats,
- Figur 4: eine vierte schematische Querschnittsdarstellung eines erfindungsgemäßen Epitaxiesubstrats und
- Figur 5: eine schematische Darstellung mehrerer Verfahrensschritte eines erfindungsgemäßen Verfahrens anhand von Querschnitten.

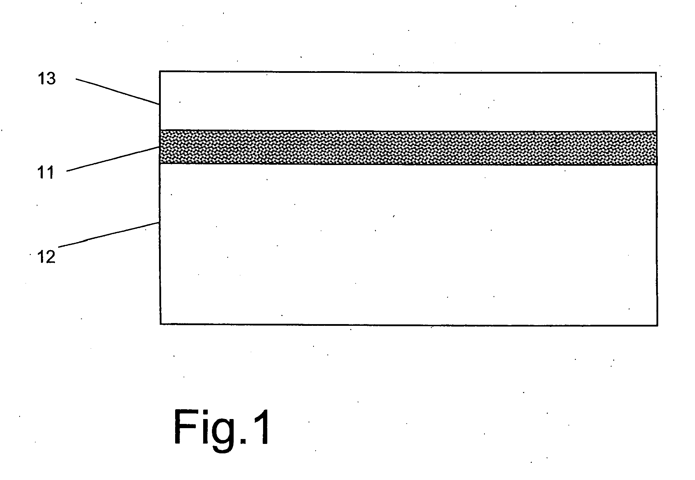

Figur 1 zeigt ein erstes Ausführungsbeispiel der Erfindung anhand eines schematischen Querschnitts durch ein erfindungsgemäßes Epitaxiesubstrat. Auf einem Wafer 12 ist eine poröse Schicht 11 angeordnet, die von einem Halbleiterkristall 13 überwachsen ist. Der Wafer 12 enthält ein III-V-Halbleitermaterial. Insbesondere handelt es sich bei dem Wafer 12 um einen Galliumarsenidwafer.

Die poröse Schicht 11 auf dem Galliumarsenidwafer 12 wird durch elektrochemische Oxidation erzeugt. Diese poröse Schicht 11 kann durch einen Halbleiterkristall 13 überwachsen sein. Der Halbleiterkristall 13 weist dabei ebenfalls ein III-V-Halbleitermaterial auf oder ein Halbleitermaterial, welches in seiner Gitterkonstanten an das Gitter des Wafers 12 angepasst ist. Der Halbleiterkristall weist beispielsweise Galliumarsenid (GaAs), Indiumgalliumarsenid (InGaAs), Galliumaluminiumarsenid (GaAlAs), Indiumgalliumaluminiumarsenid (InGaAlAs) oder weitere beliebige III-V-Halbleitermaterialien auf. Insbesondere ist die kristallographische Fernordnung des Wafers 12 über die poröse Schicht 11 hinweg im Halbleiterkristall 13 weiterhin erhalten.

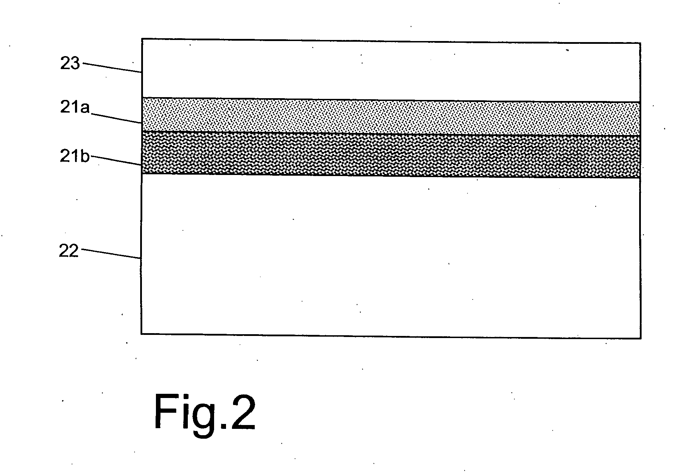

Figur 2 zeigt eine andere Ausführungsform eines erfindungsgemäßen Epitaxiesubstrats. Ein III-V-Halbleitermaterial aufweisender Wafer 22, insbesondere ein Galliumarsenidwafer, ist von einer aus zwei Teilschichten 21a, 21b gebildeten porösen Schicht überdeckt. Auf den porösen Teilschichten 21a, 21b ist ein Halbleiterkristall 23 angeordnet. Die poröse Schicht weist in einem ersten Teilbereich 21b eine größere durchschnittliche Porengröße auf als in einem zweiten Teilbereich 21a. Die poröse Schicht 21a, 21b wird zum Beispiel durch elektrochemische Oxidation des Wafers 22 erzeugt.

Der Teilbereich 21a der porösen Schicht mit einer geringeren durchschnittlichen Porengröße ermöglicht, dass der auf seiner Oberseite gewachsene Halbleiterkristall 23 beim Wachstum eine geringere Tendenz zur Bildung von Gitterfehlern zeigt. Die Erzeugung unterschiedlicher Porengrößen innerhalb von Teilbereichen der porösen Schicht wird typischerweise durch Steuerung der elektrochemischen Oxidation erreicht. Allerdings kann auch durch Einstellung der Wachstumsbedingungen bei der Erzeugung des Halbleiterkristalls 23 in einem Übergangsbereich 21a eine weiterhin poröse Struktur mit beispielsweise einer kleineren durchschnittlichen Porengröße erzeugt werden. Auf der Oberseite des Halbleiterkristalls 23 des Epitaxiesubstrats lassen sich nahezu beliebige Halbleiterstrukturen durch epitaktisches Wachstum erzeugen.

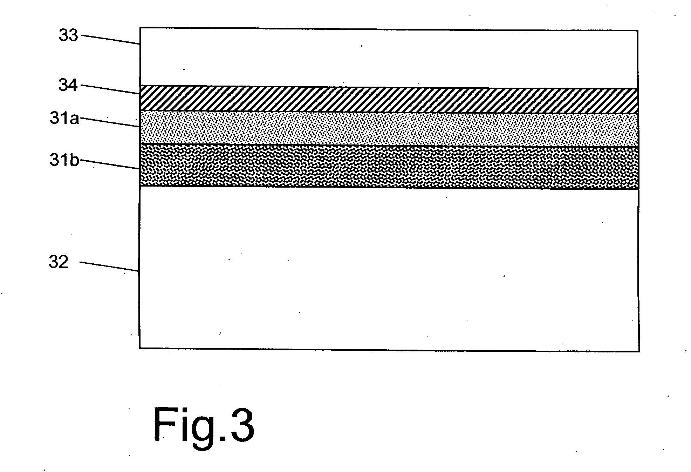

Figur 3 zeigt ein weiteres Ausführungsbeispiel eines Epitaxiesubstrats. Auf einem Wafer 32 ist eine zwei Teilschichten enthaltende poröse Schicht 31a, 31b angeordnet, die in einem Teilbereich 31b eine größere durchschnittliche Porengröße aufweist als in einem zweiten Teilbereich 31a. Weitere Ausführungsformen sehen auch vor, dass die poröse Schicht mehr als zwei Teilbereiche mit unterschiedlichen Porengrößen aufweist. Insbesondere sind drei oder mehr Teilbereiche möglich, bei denen sich an den Begrenzungsflächen eines mittleren Teilbereichs mit einer großen durchschnittlichen Porengröße poröse Teilbereiche mit kleineren durchschnittlichen Porengrößen anschließen.

In dem Ausführungsbeispiel gemäß Figur 3 ist oberhalb der porösen Schicht 31a, 31b eine Ätzstoppschicht 34 eingefügt. Diese Ätzstoppschicht 34 ist dazu geeignet, den Halbleiterkristall 33, der oberhalb der Ätzstoppschicht 34 liegt, bei einer Entfernung der porösen Schicht 31a, 31b mittels eines Ätzverfahrens, insbesondere eines nasschemischen Ätzverfahrens, vor der Ätzlösung zu schützen.

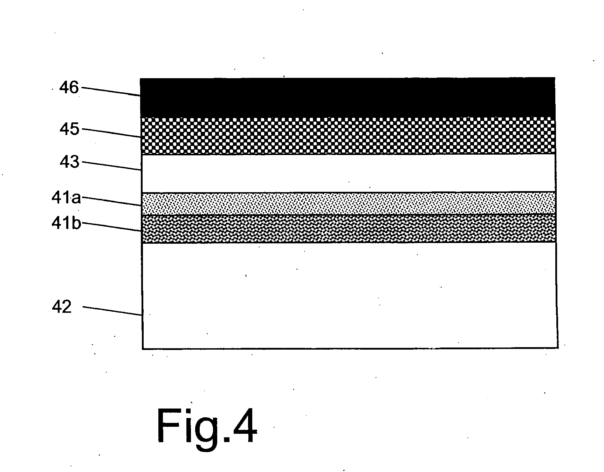

Figur 4 zeigt eine weitere Ausführungsform eines Epitaxiesubstrats. Auf einem Wafer 42 ist eine poröse Schicht 41a, 41b angeordnet, die in einem ersten Teilbereich 41b eine größere durchschnittliche Porengröße aufweist als in einem zweiten Teilbereich 41a. Die poröse Schicht 41a, 41b ist von einem Halbleiterkristall 43 überwachsen. Auf dem Halbleiterkristall 43 ist eine Diodenstruktur 45 aufgewachsen.

Diese nicht näher detaillierte Diodenstruktur 45 enthält beispielsweise nicht dargestellte p-dotierte und n-dotierte Schichten, eine aktive Zone, Reflektorschichten sowie weitere funktionelle Schichten. Bei der Diodenstruktur 45 kann es sich bevorzugt um eine Leuchtdiodenstruktur, eine Laserdiodenstruktur oder eine IR-Diodenstruktur handeln. Oberhalb der Diodenstruktur 45 ist eine Verbindungsschicht 46 angeordnet. Die Verbindungsschicht 46 ist dabei insbesondere geeignet, als Teil des Tranferschritts der Dünnschichttechnologie das Epitaxiesubstrat mit einem Ersatzsubstrat zu verbinden.

Durch die Ausgestaltung der porösen Schicht 41, 41b in zwei Teilbereichen mit unterschiedlichen Porengrößen wird ein gleichmäßigeres Überwachsen der porösen Schicht mittels eines Halbleiterkristalls 43 erreicht. Insbesondere werden Gitterfehler verringert beziehungsweise vermieden, wodurch ein gleichmäßiges Aufwachsen einer Leuchtdiodenstruktur beziehungsweise einer Laserstruktur ermöglicht wird.

Mögliche Ausführungsformen beschränken sich allerdings nicht auf das Aufwachsen von Leuchtdioden-, Laserdiodenbeziehungsweise IR-Diodenstrukturen oberhalb des Halbleiterkristalls 43. Vielmehr können alle beliebigen optoelektronischen oder elektronischen Strukturen oberhalb des Halbleiterkristalls 43 gewachsen werden. Besonders bevorzugt weist der Halbleiterkristall 43 eine identische oder ähnliche Gitterkonstante auf wie der zugrunde liegende Halbleiterwafer 42. Besonders bevorzugt handelt es sich bei dem Wafer 42 um einen Galliumarsenidwafer.

In einer weiteren Ausgestaltung weist das gesamte Epitaxiesubstrat von den aufgewachsenen Strukturen 45 bis zum Wafer 42 die gleiche kristallographische Fernordnung auf, wobei die Fernordnung über die poröse Schicht 41a, 41b vermittelt wird. Weitere Ausführungsbeispiele der Erfindung weisen zusätzliche Schichten innerhalb des Epitaxiesubstrats wie Ätzstoppschichten, Reflektorschichten oder Gitteranpassungsschichten auf.

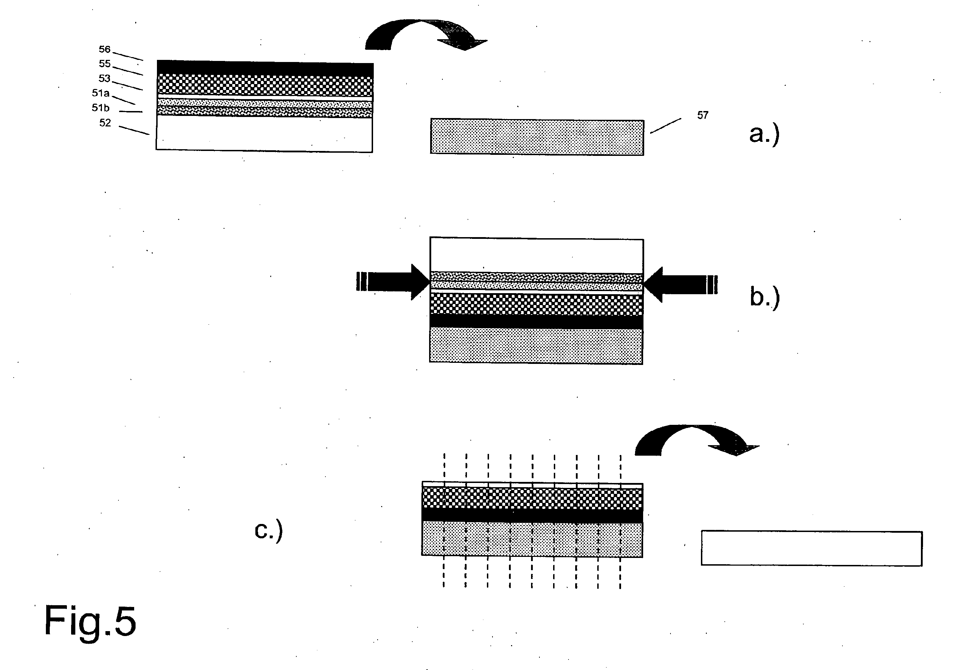

Figur 5 zeigt die schematische Darstellung eines erfindungsgemäßen Verfahrens zur gleichzeitigen Herstellung mehrerer Dünnschicht-Halbleiterchips. Figur 5a) zeigt links ein Epitaxiesubstrat gemäß Figur 4 mit angepassten Bezugszeichen bzw. Schraffuren. Dieses Epitaxiesubstrat wird mittels der Verbindungsschicht 56 mit einem Ersatzsubstrat 57 in Kontakt gebracht und über eine Verbindungstechnik fest verbunden. In Figurenteil 5b) ist durch zwei Pfeile auf der linken und der rechten Seite schematisch dargestellt, wie die poröse Schicht durchtrennt wird.

Die Durchtrennung der porösen Schicht kann sowohl durch mechanische Vorgänge als auch durch Ätzvorgänge bewirkt werden. Dabei wird die poröse Schicht durchtrennt oder auch vollkommen entfernt. Eventuelle Reste der porösen Schicht können in späteren Verfahrensschritten auch durch Schleifen oder Läppen oder in sonstiger Weise geglättet beziehungsweise entfernt werden. Nach Durchtrennung der porösen Schicht 51a, 51b gemäß Figurenteil 5b) wird, wie in Figurenteil 5c) schematisch dargestellt, der ursprüngliche Wafer bzw. das Wachstumssubstrat 52 entfernt. Im linken Teil der Figur 5c) ist dargestellt, wie die epitaktisch gewachsenen Strukturen über eine Verbindungsschicht fest mit dem Ersatzsubstrat 57 verbunden sind.

Oberhalb der epitaktisch gewachsenen Strukturen befindet sich noch ein Rest des Halbleiterkristalls, mit dem beim Epitaxiesubstrat die poröse Schicht überwachsen war. Dieser Halbleiterkristall ist entweder sehr dünn ausgestaltet, so dass er eine eventuelle Strahlungsauskopplung aus den strukturierten Schichten nicht stört, oder er wird durch Polieren oder durch selektives Ätzen vollständig abgetragen. Die erzeugten Strukturen können dann beispielsweise zu einzelnen Chips vereinzelt werden. Schematisch sind in Figur 5c) gestrichelte Linien dargestellt, entlang denen eine Durchtrennung der Heterostruktur erfolgen kann. Besteht die epitaxierte Struktur 55 aus einer LED-Struktur, so wird durch Vereinzelung analog der Darstellung in Figur 5c) eine Vielzahl von Dünnschichtfilm-LED-Chips erhalten.

## Patentansprüche

1. III-V-Halbleiter aufweisendes Epitaxiesubstrat, das mindestens eine Schicht porösen III-V-Halbleitermaterials enthält.

2. Epitaxiesubstrat nach Anspruch 1,
**dadurch gekennzeichnet, dass**
das Epitaxiesubstrat überwiegend III-V-Halbleitermaterialien aufweist.

3. Epitaxiesubstrat nach einem der vorangegangenen Ansprüche,
**dadurch gekennzeichnet, dass**
die mindestens eine Schicht einen ersten Teilbereich und einen zweiten Teilbereich aufweist, wobei die Porengröße in einem ersten Teilbereich größer als in einem zweiten Teilbereich ist.

4. Epitaxiesubstrat nach einem der vorangegangenen Ansprüche,
**dadurch gekennzeichnet, dass** innerhalb der porösen Schicht die kristallographische Fernordnung beibehalten wird.

5. Epitaxiesubstrat nach einem der vorangegangenen Ansprüche,
**dadurch gekennzeichnet, dass** die poröse Schicht durch einen III-V-Halbleiterkristall überwachsen ist.

6. Epitaxiesubstrat nach einem der vorangegangenen Ansprüche,
**dadurch gekennzeichnet, dass**
das Epitaxiesubstrat mindestens eine Ätzstoppschicht aufweist.

7. Epitaxiesubstrat nach einem der vorangegangenen Ansprüche,
**dadurch gekennzeichnet, dass** die Porengröße innerhalb der porösen Schicht einen Gradienten aufweist.

8. Epitaxiesubstrat nach einem der vorangegangenen Ansprüche,
**dadurch gekennzeichnet, dass** auf einer Oberfläche des Epitaxiesubstrats mindestens eine Leuchtdiodenstruktur angeordnet ist.

9. Epitaxiesubstrat nach Anspruch 8,
**dadurch gekennzeichnet, dass** auf der mindestens einen Leuchtdiodenstruktur mindestens eine Verbindungsschicht, insbesondere zur Verbindung mit einem Ersatzsubstrat, angeordnet ist.

10. Bauelement, das mit einem Epitaxiesubstrat gemäß einem der vorangegangenen Patentansprüche hergestellt ist.

11. Verfahren zur Herstellung eines Epitaxiesubstrats umfassend die Schritte:
- Bereitstellen eines III-V-Halbleiters,
- Erzeugen einer porösen Schicht durch elektrochemische Oxidation
- Überwachsen der porösen Schicht mit einem III-V-Halbleiter.

12. Verfahren nach Anspruch 11,
**dadurch gekennzeichnet, dass**
die Porenstruktur der porösen Schicht durch Steuerung der elektrochemischen Oxidation in einem ersten Teilbereich eine andere durchschnittliche Porengröße aufweist als in einem zweiten Teilbereich.

13. Verfahren nach einem der Ansprüche 11 oder 12,
**dadurch gekennzeichnet, dass** mittels epitaktischem Wachstum mindestens eine LED-Struktur auf dem Epitaxiesubstrat erzeugt wird.

14. Verfahren nach Anspruch 13,
bei dem zusätzlich eine Verbindungsschicht auf der LED-Struktur aufgebracht wird.

15. Verfahren nach Anspruch 14,
bei dem zusätzlich ein Ersatzsubstrat auf der Verbindungsschicht aufgebracht wird.

16. Verfahren zur Herstellung eines Bauelements, insbesondere einer LED, umfassend die Schritte:
- Herstellung eines III-V- Epitaxiesubstrats, das mindestens eine Schicht porösen III-V-Halbleitermaterials enthält,
- Wachsen mindestens einer LED-Struktur auf dem Epitaxiesubstrat,
- Verbinden der LED-Struktur mit einem Ersatzsubstrat,
- Ablösung des III-V-Substrates mittels Durchtrennung oder Zerstörung der Schicht porösen III-V-Halbleitermaterials.

17. Verfahren nach Anspruch 16,
bei dem zusätzlich mindestens ein LED-Chip vereinzelt wird.
